## Europäisches Patentamt
## European Patent Office
## Office européen des brevets

(19)

(11) Veröffentlichungsnummer: **0 045 814**
**B1**

(12)
# EUROPÄISCHE PATENTSCHRIFT

(45) Veröffentlichungstag der Patentschrift:
**14.12.83**

(51) Int. Cl.³: **F 16 F 1/10, G 01 D 11/18**

(21) Anmeldenummer: **80104607.9**

(22) Anmeldetag: **05.08.80**

(54) **Einstellbare Messspiralfeder.**

(43) Veröffentlichungstag der Anmeldung:
**17.02.82 Patentblatt 82/7**

(45) Bekanntmachung des Hinweises auf die Patenterteilung:
**14.12.83 Patentblatt 83/50**

(84) Benannte Vertragsstaaten:
**CH DE FR GB IT LI**

(56) Entgegenhaltungen:
**AT - B - 310 509**
**AT - B - 311 194**
**DE - A - 1 962 278**
**DE - C - 361 411**
**DE - C - 694 079**
**DE - C - 848 456**
**DE - C - 848 613**
**DE - C - 922 453**
**US - A - 1 661 214**
**US - A - 2 855 887**
**US - A - 3 247 724**

(73) Patentinhaber: **Közuti Közlekedési Tudományos Kutato Intézet, Thán Károly u. 3-5, Budapest 1119 (HU)**

(72) Erfinder: **Böhm, Nándor, Damjanich u. 54, Budapest 1071 (HU)**
Erfinder: **Böhm, János, Zalai ut 1/c, Budapest 1125 (HU)**
Erfinder: **Böhm, Robert, Piroska u. 9, Budapest 1016 (HU)**

(74) Vertreter: **Viering, Hans-Martin, Dipl.-Ing. et al, Patentanwälte Viering & Jentschura Steinsdorfstrasse 6, D-8000 München 22 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Einstellbare Messspiralfeder

Die Erfindung betrifft eine einstellbare Messspiralfeder für Messinstrumente, wie Leistungs-, Widerstands-, Geschwindigkeits- und Kraftstoff-verbrauchs-Messinstrumente von Kraftfahrzeu-gen und Arbeitsmaschinen, mit einem entlang we-nigstens der äusseren Federwindung verlaufen-den Haltegehäuse und mit einer mit dem äusseren Federbandende zusammenwirkenden Verstellvorrichtung, mit welcher die wirksame Länge des Federbandes einstellbar ist.

Eine Messspiralfeder dieser Bauart ist aus der DE-A Nr. 1962278 bekannt. Bei der bekannten Messspiralfeder kann ausser der Einstellbarkeit der Federspannung auch der wirksame Bereich der Federkennlinie eingestellt werden. Dies wird dadurch erreicht, dass die Befestigungsstelle, an der das äussere Federende festgelegt ist, entlang der Spiralwindungen verstellt wird, so dass dadurch die wirksame Länge der Federwindungen verstellt wird.

Die angesprochenen Messinstrumente, haupt-sächlich Geschwindigkeits- bzw. Drehzahl-Mes-sinstrumente, Dynamometer und dergleichen, messen fortlaufend einen kontinuierlich auftretenden Vorgang und zeigen dessen Änderungen an; ggf. werden die Messergebnisse auch registriert. Die zu messenden Vorgänge hängen im allgemeinen mit wichtigen Vorschriften zusammen: so z.B. bei einem Tachometer, durch welchen der zulässige Verkehr der Strassenfahrzeuge kontrolliert, überwacht und gewährleistet werden soll. In der Praxis werden aufgrund der kontrollierten und gemessenen Vorgänge die Funktion bzw. der Betrieb der Maschinen beeinflusst, Arbeitsprozesse gesteuert und auch automatisiert. Durch Mess-instrumente dieser Art werden die beobachteten Vorgänge mit Hilfe eines an einer Welle wirkenden Momentes angezeigt, durch welches ein entsprechend grosses Gegenmoment in einer an der Welle angreifenden Messspiralfeder hervorgerufen wird. Wenn diese Momente linear sind, werden die Messergebnisse an einer linearen Skala dargestellt, wobei die Messspiralfeder des Messinstrumentes eine Federkennlinie aufweist, die zu dem Messausschlag bzw. dem Messmoment linear ist. Messvorgänge, die nicht linear sind, können durch verschiedene, komplizierte Mechanismen in lineare Vorgänge umgewandelt werden: z.B. bei Messinstrumenten, von welchen eine strömende Flüssigkeitsmenge registriert wird. Es gibt Momentfühler, durch welche die Messwerte an einer empirischen Skala angezeigt werden (z.B. an einer linearen Skala bei gewissen Kilometergeschwindigkeits-Messinstrumenten). Oft kommt es vor, dass die Verteilung des Messbereiches infolge einer übertriebenen Länge des ganzen Bereiches zu eng wird und somit ein hinreichend genauer Wert nicht angezeigt werden kann.

Durch die Erfindung werden diese Nachteile beseitigt und eine einstellbare Messspiralfeder geschaffen, durch welche es im Zusammenwirken mit im übrigen unveränderten Messinstrumenten und Geräten ermöglicht ist, die gemessenen Werte an einer beliebig gewählten Skala oder Skalenverteilung anzuzeigen. So z.B. sollen die Messwerte mittels eines ein lineares Moment abfühlenden Zeigers an einer logarithmischen Skala, oder eines ein quadratisch zunehmendes Moment abfühlenden Zeigers an einer linearen oder logarithmischen Skala angezeigt werden.

Diese Aufgabe wird erfindungsgemäss dadurch gelöst, dass das Haltegehäuse mit einer zwischen die Windungen der Messspiralfeder eingreifenden Haltespirale versehen ist, die dreheinstellbar ist und an welcher das Federband mit seinem an sein äusseres Federbandende angrenzenden Bandabschnitt anliegt, und dass das Federband einen von den äusseren Federwindungen bis zu den inneren Federwindungen kontinuierlich zunehmenden oder abnehmenden Bandquerschnitt aufweist.

Dabei kann der zunehmende oder abnehmende Bandquerschnitt bei konstanter Banddicke durch eine in dem Federband ausgebildete Ausnehmung erreicht werden.

Es ist zwar aus der DE-C Nr. 848456 bekannt, bei einer Feder, die für die Federung von Fahrzeugen verwendet wird, einen über deren Länge hin veränderlichen Bandquerschnitt vorzusehen, um dadurch eine Änderung der Federcharakteristik zu erzielen. Ferner ist es aus dieser Veröffentlichung bekannt, in der Federblattfläche parallele, schräge oder kurvenförmige Schlitze vorzusehen, durch die eine flächige Anlage des Federbandes an dem Haltegehäuse erzielt werden soll.

Ein Vorteil der Erfindung besteht darin, dass die visuelle Darstellung der zu messenden Ergebnisse mit einem verschiedene Momente abfühlenden Zeiger an einer logarithmischen Skala durchgeführt werden kann. Hierbei werden die durch Messinstrumente erhaltenen Messwerte miteinander verglichen bzw. aus den Messwerten in bestimmter Weise zusammengesetzte Werte gebildet. Bisher wurden solche zusammengesetzte Werte rechnerisch, d.h. mit Hilfe einer Rechenmaschine oder eines Rechenschiebers, jeweils mit willkürlich ausgewählten Messwerten durchgeführt. Bei einem mit der erfindungsgemässen Messspiralfeder ausgebildeten Drehanzeigeinstrument mit logarithmischen Skalen sind kon-zentrische Rechenscheiben angeordnet, die unab-hängig voneinander mit einem Zeiger zusammenwirken, so dass — ähnlich wie mit dem Schieber eines Rechenstabes — der jeweils gewünschte Wert angezeigt wird.

*Beispiel a:*

Die augenblickliche Geschwindigkeit eines Fahrzeuges wird durch ein Messinstrument in Kilometer/Stunde, und der jeweilige Kraftstoffverbrauch durch ein Verbrauchsmessgerät in Liter/ Stunde angezeigt. Wenn beide Instrumente kon-zentrisch betätigte logarithmische Skalen auf-weisen, kann der momentane spezifische Verbrauch in Liter/100 km angezeigt werden. Dieser Wert ist repräsentativ für ein wirtschaftliches oder unwirtschaftliches Autofahren. Jedoch konnte dieser Wert bisher aus den gesondert ablesbaren Werten nur durch Rechnen oder mit Hilfe eines Rechenstabes theoretisch ermittelt werden, nicht aber während der Fahrt.

*Beispiel b:*

Das am Bremsprüfstand gemessene Moment und die Drehzahl eines Otto- oder Dieselmotors werden zur Bestimmung der Motorleistung zugrunde gelegt. Wenn beide Fühler mit einer logarithmischen Skala versehen werden, kann ein Messgerät erhalten werden, durch welches die Leistung angezeigt wird.

*Beispiel c:*

In der Elektrotechnik werden die Spannung (V) und die Stromstärke (A) durch einfache Messgeräte separat gemessen. Wenn die gemessenen Werte an einer logarithmischen Skala als zusammengesetzter Wert angezeigt werden, so kann man die augenblickliche Leistung (W) oder den augenblicklichen Widerstandswert ($\Omega$) erhalten. Gleichzeitig werden durch dieses Gerät die abgefühlten Einzelwerte angezeigt.

*Beispiel d:*

Die Erfindung kann auch auf dem Gebiet der Technologie, der Meteorologie, der Automatisierung und noch auf sonstigen Gebieten verwendet werden. In Warenhäusern können z.B. die angezeigten Messwerte aus Gewichtsmessungen mit einstellbaren Einzelpreisen durch eine Drehscheibe zusammengesetzt und so der Gesamtpreis angezeigt werden. Dadurch werden sowohl der Einkauf wie auch die Kontrolle vereinfacht.

Derartige Messinstrumente, wie sie in den oben angeführten Beispielen a bis d angegeben sind, können mit Hilfe der erfindungsgemässen einstellbaren Messspiralfeder verwirklicht werden. Ein grosser Vorteil der Erfindung liegt darin, dass die erfindungsgemäss gestaltete Messspiralfeder kleine Abmessungen und eine kleine Masse hat. Sie ist im Grunde genommen ein kleiner Bestandteil, der gegen die gebräuchliche Messspiralfeder ausgetauscht wird, während im übrigen die bisher verwendeten Messinstrumente, Fühler usw. unverändert beibehalten werden können.

Bei der erfindungsgemässen Messspiralfeder kann die Federkennlinie, d.h. die Funktion der zur Erzeugung des dem jeweiligen Messmoment entgegenwirkenden Gegenmomentes geleisteten Federarbeit oder elastischen Rückstellarbeit, durch entsprechende Wahl der Querschnittsänderung des Federbandes im voraus auf einen gewünschten Verlauf geformt werden und durch Einstellung der wirksamen Länge der Messspiralfeder kann ein gewünschter Bereich dieser Federkennlinie ausgewählt und modifiziert werden.

Die Erfindung wird im folgenden anhand bevorzugter Ausführungsformen, die aus der Zeichnung ersichtlich sind, erläutert. In der Zeichnung zeigt:

Fig. 1 in Draufsicht eine in einem Haltegehäuse angeordnete Messspiralfeder,

Fig. 2 in Draufsicht eine andere Ausführungsform, insbesondere des Haltegehäuses einer einstellbaren Messspiralfeder gemäss der Erfindung, und

Fig. 3 in Draufsicht das abgewickelte Federband der Messspiralfeder, das eine die Querschnittsänderung des Federbandes herbeiführende Ausnehmung aufweist.

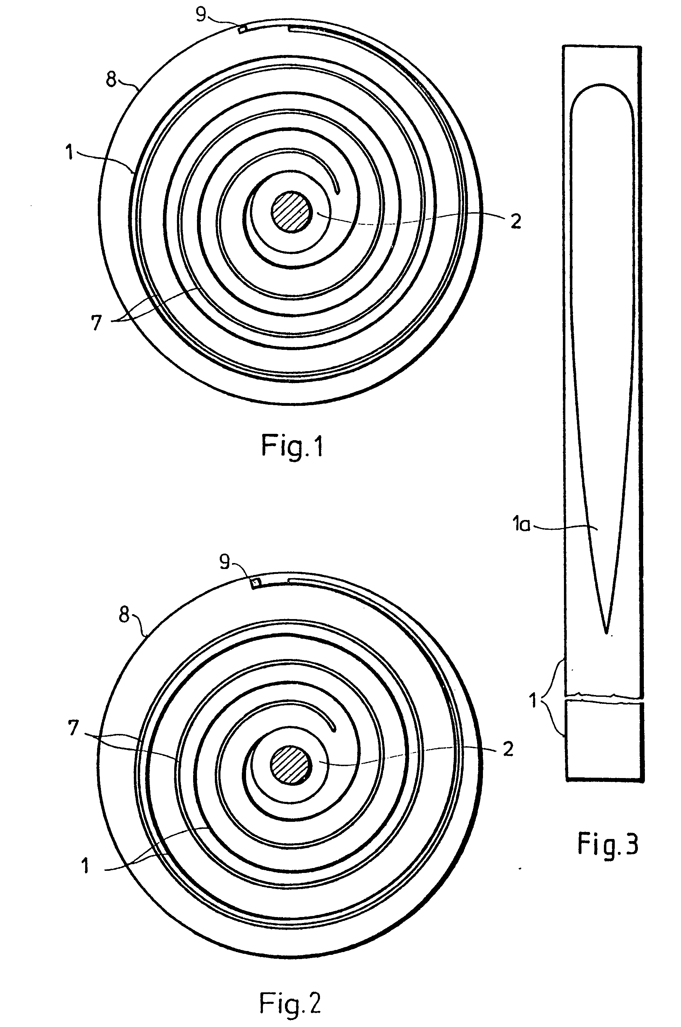

Wie aus der Zeichnung ersichtlich, ist das innere Federende der Messspiralfeder 1 fest mit einem Ring 2, dem sogenannten Federkern, verbunden, der fest auf einer Zeigerwelle eines Messinstrumentes sitzt, so dass auf die Zeigerwelle das von der Messspiralfeder 1 erzeugte Rückstellmoment oder Gegenmoment wirkt. Bei der aus Fig. 1 ersichtlichen Ausführungsform ist die Messspiralfeder 1 in einem Haltegehäuse untergebracht, das eine Haltespirale 7 aufweist, die als spiralförmig verlaufende Rippe von einer Halteplatte 8 absteht und zwischen die Windungen der Messspiralfeder 1 eingreift. Der Verlauf der Federwindungen der Messspiralfeder 1 ist daher durch deren Führung an der Haltespirale 7 an deren Verlauf angepasst und daher auf einen gewünschten Verlauf vorbestimmt. Dabei liegt hier (Fig. 1) die Messspiralfeder 1 mit ihrem an ihr äusseres Federende 9 angrenzenden Bandabschnitt an der Aussenseite des äusseren Windungsabschnittes der Haltespirale 7 an. Durch Drehung der Halteplatte 8 und damit der Haltespirale 7 kann die Länge des an der Haltespirale 7 anliegenden Bandabschnittes der Messspiralfeder 1 auf einen gewünschten Wert eingestellt werden.

Gemäss Fig. 2 liegt die Messspiralfeder 1 mit ihrem äusseren Bandabschnitt an der Innenseite der Haltespirale 7 an, so dass hier die Drehrichtung der Halteplatte 8 und damit der Haltespirale 7 für das Anlegen der äusseren Windungen der Messspiralfeder 1 umgekehrt wie für die aus Fig. 3 ersichtliche Ausführungsform ist. Durch Verdrehung der Haltespirale 7 werden die Windungen der Messspiralfeder 1 mehr oder weniger an die Haltespirale 7 angelegt, so dass die wirksame Länge der Messspiralfeder 1 und dadurch der wirksame Bereich ihrer Federkennlinie durch Veränderung des Drehwinkels der Haltespirale 7 gesteuert eingestellt werden können. Die eine logarithmische Kennlinie aufweisende Messspiralfeder 1 kann auch durch über die Federlänge hin veränderliche Steigungen der Federwindungen bzw. veränderliche Querschnittsabmessungen der Windungszwischenräume realisiert werden. Diese Massnahme ist leicht durchführbar, wenn die Haltespirale 7, an welcher die Federwindungen geführt sind, in ihrem Verlauf entsprechend gestaltet ist.

Das Material des Federbandes der Messspiralfeder 1 kann nicht nur aus den herkömmlichen Metallen, sondern auch aus Kunststoff entsprechender Elastizität, zweckmässig aus glasfaserverstärktem Kunststoff hergestellt werden. Auch in dieser Ausführungsform ist die Messspiralfeder 1 derart ausgebildet, dass sie entlang der Länge ihres Federbandes zweckmässig eine unveränderte Dikke, jedoch allmählich zu- oder abnehmende Breite aufweist, so dass entsprechend ihr Querschnitt veränderlich ist.

Der rechteckige Querschnitt des Federbandes der Messspiralfeder 1 ist — wie aus Fig. 3 ersichtlich — über die Bandlänge hin kontinuierlich ab- oder zunehmend ausgebildet. Die Abnahme oder Zunahme des Bandquerschnittes werden vorzugsweise unter Beibehaltung einer konstanten Banddicke durch Änderung der Breite des Bandes durchgeführt, weil dies leichter bewerkstelligt werden kann als eine Änderung der Banddicke, für welche eine genaue Steuerung des Walzwerkes erforderlich ist.

Die Verminderung des Federquerschnittes bzw. die Änderung der Breite des Federbandes kann durch einen aus dem Federband ausgestanzten Ausschnitt 1a erhalten werden, wie er aus Fig. 3 ersichtlich ist.

Die Funktion der Breitenänderung des Federbandes bzw. der Querschnittsänderung der Messspiralfeder 1 kann rechnerisch in Abhängigkeit vom jeweils gewünschten Drehmoment und Drehwinkel zur Erzielung einer gewünschten Federkennlinie ausgewählt werden.

Die Querschnittsänderung des die Messspiralfeder 1 bildenden Federbandes ist vorzugsweise derart, dass die Messspiralfeder 1 eine logarithmische Kennlinie erhält.

Die aus den Fig. 1 und 2 ersichtlichen Ausführungsformen stellen eine bevorzugte Lösung dar, weil unter Beibehaltung des Wesens der Erfindung die Messspiralfeder 1 aus Kunststoff und die Halteplatte 8 mit der Haltespirale 7 aus einem einzigen Stück durch Pressen hergestellt sein können. Die Messspiralfeder 1 ist in ihrem spiralig aufgewickelten Zustand in der Haltespirale 7 und an der Halteplatte 8 gehalten und kann mit dieser als Baueinheit in ein Federgehäuse eingesetzt werden, wobei das äussere Federende 9 in einer Öffnung des Federgehäuses eingeklemmt wird. Die Halteplatte 8 mit der Haltespirale 7 sind im Federgehäuse drehbar gelagert und können beispielsweise mit einer Einstellschnecke, die im Federgehäuse drehbar gelagert ist und in eine Verzahnung am Aussenrand der Halteplatte 8 eingreift, durch Drehung der Halteplatte 8 und daher der Haltespirale 7 für die Einstellung der Federkennlinie verdreht werden.

Die Messspiralfeder 1 kann nach ihrer beschriebenen Ausführungsform mit der Halteplatte 8 als Baueinheit gehandhabt werden und bildet mit dieser eine auswechselbare Einheit, die in das Federgehäuse eingesetzt werden kann. Die Anzahl und die Länge der das Federband führenden Haltespirale 7 an der Halteplatte 8 werden entsprechend der Länge der Messspiralfeder bzw. der Windungszahl derselben gewählt.

Zur Herstellung der erfindungsgemässen Messspiralfeder 1 kann ein Material gewählt werden, bei welchem die Änderung des Bandquerschnittes nicht erforderlich ist, weil die logarithmische Ausbildung der Federkennlinie auch durch eine entsprechend veränderliche Steigung der Federwindungen erreicht werden kann, die durch einen entsprechenden Verlauf der das Federband führenden Haltespirale 7 bestimmt ist. Das Material der Messspiralfeder 1 ist hierbei ein Metall, ein nichtmetallisches Material, z.B. Glas, Kunststoff oder ein sonstiges Material mit einer entsprechenden Elastizität.

**Patentansprüche**

1. Einstellbare Messspiralfeder (1) für Messinstrumente, wie Leistungs-, Widerstands-, Geschwindigkeits- und Kraftstoffverbrauchs-Messinstrumente von Kraftfahrzeugen und Arbeitsmaschinen, mit einem entlang wenigstens der äusseren Federwindung verlaufenden Haltegehäuse und mit einer mit dem äusseren Federbandende zusammenwirkenden Verstellvorrichtung, mit welcher die wirksame Länge des Federbandes einstellbar ist, dadurch gekennzeichnet, dass das Haltegehäuse mit einer zwischen die Windungen der Messspiralfeder (1) eingreifenden Haltespirale (7) versehen ist, die dreheinstellbar ist und an welcher das Federband mit seinem an sein äusseres Federbandende angrenzenden Bandabschnitt anliegt, und dass das Federband einen von den äusseren Federwindungen bis zu den inneren Federwindungen kontinuierlich zunehmenden oder abnehmenden Bandquerschnitt aufweist.

2. Messspiralfeder nach Anspruch 1, dadurch gekennzeichnet, dass der zunehmende oder abnehmende Bandquerschnitt bei konstanter Banddicke durch eine in dem Federband ausgebildete Ausnehmung (1a) ausgebildet ist.

3. Messspiralfeder nach einem der Ansprüche 1 oder 2, dadurch gekennzeichnet, dass sie mit dem Haltegehäuse als auswechselbare Baueinheit in das Messinstrument einsetzbar ist.

4. Messspiralfeder nach einem der Ansprüche 1 bis 3, insbesondere für mechanische Messinstrumente, dadurch gekennzeichnet, dass das Federband aus entsprechend elastischem Metall-, Glasoder Kunststoffmaterial besteht und die Steigung der Federwindungen veränderlich ist.

**Claims**

1. An adjustable measuring coil-spring (1) for measuring instruments such as dynamometers, ohmmeters, speedometers and fuel-consumption gauges for motor vehicles and machines performing work, comprising a support housing extending at least along the outer turn of the coil-spring and an adjustment device which co-operates with the end of the spring-band and with the aid of which the operative length of the spring-band can be adjusted, characterized in that the support housing is provided with a retaining coil (7) engaging between the turns of the rotatably adjustable measuring coil-spring (1) against which the spring-band bears by way of its portion adjoining the outer end of the spring-band, and that the spring-band has a cross-section that continuously increases or decreases from the outer spring turns to the inner spring turns.

2. A measuring coil-spring according to claim 1, characterized in that the increasing or decreasing cross-section of the spring-band is formed by a cut-out (1a) in the spring-band, the thickness of the band remaining constant.

3. A measuring coil-spring according to one of claims 1 or 2, characterized in that, together with the support housing, it is insertable into the measuring instrument as an exchangeable constructional unit.

4. A measuring coil-spring according to one of claims 1 to 3, particularly for mechanical measuring instruments, characterized in that the spring-band is made of suitable metal, glass or plastics and the pitch of the coil-spring is variable.

**Revendications**

1. Ressort spiral réglable de mesure (1) pour instruments de mesure, tels qu'instruments de mesure de la puissance, de la résistance, de la vitesse et de la consommation de carburant, pour des véhicules automobiles et des machines opératrices, ressort comportant un carter de support s'étendant au moins le long de la spire extérieure du ressort, ainsi qu'un dispositif de réglage coopérant avec l'extrémité extérieure du ruban élastique du ressort et permettant d'ajuster la longueur effective de ce ruban, caractérisé en ce que le carter de support est pourvu d'une spirale de support (7) s'engageant entre les spires du ressort spiral de mesure (1), ladite spirale de support étant ajustable en rotation, cependant que le ruban élastique est appliqué, à sa partie adjacente à l'extrémité extérieure du ruban, contre ladite spirale de support, et en ce que le ruban élastique présente une section transversale croissante ou décroissante de manière continue à partir des spires extérieures du ressort vers les spires intérieures de celui-ci.

2. Ressort spiral de mesure selon la revendication 1, caractérisé en ce que la section transversale croissante ou décroissante du ruban, pour une épaisseur constante de celui-ci, est obtenue par un évidement (1a) ménagé dans le ruban élastique.

3. Ressort spiral de mesure selon l'une des revendications 1 ou 2, caractérisé en ce qu'il est susceptible d'être monté dans l'instrument de mesure avec le carter de support, en tant qu'unité de construction interchangeable.

4. Ressort spiral de mesure selon l'une des revendications 1 à 3, notamment pour des instruments de mesure mécaniques, caractérisé en ce que le ruban élastique est formé d'un matériau respectivement métallique, à base de verre ou de matière synthétique, présentant une élasticité convenable, et en ce que le pas des spires du ressort est variable.

0 045 814

Fig.1

Fig.2

Fig.3